# EUROPÄISCHE PATENTSCHRIFT

(11) **EP 3 864 198 B1**
(45) Veröffentlichungstag und Bekanntmachung des Hinweises auf die Patenterteilung: **07.09.2022**
(21) Anmeldenummer: 19779481.1
(22) Anmeldetag: 27.09.2019
(51) Int. Cl.: C30B 15/20, C30B 15/26, C30B 15/14, C30B 29/06, C30B 29/08

(54) **VORRICHTUNG ZUM ZIEHEN EINES EINKRISTALLS AUS HALBLEITERMATERIAL NACH DER CZ-METHODE AUS EINER SCHMELZE UND VERFAHREN UNTER VERWENDUNG DER VORRICHTUNG**
DEVICE FOR PULLING A SINGLE CRYSTAL OF SEMICONDUCTOR MATERIAL OUT OF A MELT USING THE CZ METHOD, AND METHOD USING THE DEVICE
DISPOSITIF DE CROISSANCE PAR TIRAGE D'UN MONOCRISTAL EN MATÉRIAU SEMI-CONDUCTEUR SELON LE PROCÉDÉ CZOCHRALSKI À PARTIR D'UNE MATIÈRE EN FUSION, ET PROCÉDÉ D'UTILISATION DE CE DISPOSITIF

(30) Priorität: 12.10.2018 DE 102018217509
(43) Veröffentlichungstag der Anmeldung: 18.08.2021
(73) Patentinhaber: Siltronic AG, 81677 München (DE)
(72) Erfinder: MOLCHANOV, Alexander, 84533 Marktl (DE)
(74) Vertreter: Staudacher, Wolfgang
(86) Internationale Anmeldenummer: PCT/EP2019/076286
(87) Internationale Veröffentlichungsnummer: WO 2020/074285

(56) Entgegenhaltungen:
- EP-A1- 2 031 100
- JP-A- 2001 039 798
- US-A- 5 919 303
- US-A1- 2009 229 512

## Beschreibung

Gegenstand der Erfindung ist eine Vorrichtung und deren Verwendung zum Ziehen eines Einkristalls aus Halbleitermaterial nach der CZ-Methode aus einer Schmelze. Die Vorrichtung umfasst einen Tiegel zum Aufnehmen der Schmelze, eine Widerstandsheizung, die um den Tiegel herum angeordnet ist, ein Kamerasystem zum Beobachten einer Phasengrenze zwischen der Schmelze und dem wachsenden Einkristall und einen Hitzeschild, der im Bereich seines unteren Endes kegelstumpfförmig mit sich verjüngendem Durchmesser ausgebildet ist und der über dem Tiegel angeordnet ist und den Einkristall umgibt.

### Stand der Technik / Probleme

In EP 2 031 100 A1 ist eine Vorrichtung mit den oben erwähnten Merkmalen gezeigt und ein Verfahren zur Herstellung eines Einkristalls nach der CZ-Methode beschrieben, bei dem die Vorrichtung eingesetzt wird.

In US 5 919 303 ist ein Verfahren zum Nachbeschicken von Silizium beschrieben, wobei der Tiegel mit polykristallinem Silizium in Form von Granulat nachbeschickt wird.

JP2001-39798 A offenbart einen Hitzeschild, der zusätzlich einen inneren Zylinder aufweist, um Partikel aus Siliziumoxid (SiO) daran zu hindern, in die Schmelze zu fallen. Gelangen solche Partikel zum wachsenden Einkristall, können sie Versetzungen auslösen und den Einkristall für den vorgesehenen Zweck unbrauchbar machen. Nachteilig an diesem Hitzeschild ist, dass er den freien Blick zur Phasengrenze zwischen der Schmelze und dem wachsenden Einkristall behindert.

US 2009 0 229 512 A1 beschreibt eine Vorrichtung zum Ziehen eines Einkristalls aus Silizium. Diese Vorrichtung umfasst einen Hitzeschild, dessen Oberfläche ungleichmäßig geformt ist, wobei Höhenunterschiede der Form derart ausgeprägt sind, dass Staub daran gehindert wird, vom Hitzeschild zu fallen.

Aufgabe der vorliegenden Erfindung ist es, eine vorteilhaftere Vorrichtung mit den eingangs genannten Merkmalen vorzuschlagen, durch deren Verwendung unerwünschte Partikel weitgehend davon abgehalten werden können, in die Schmelze zu gelangen, ohne dass damit ein Nachteil verknüpft ist.

Die Aufgabe der Erfindung wird gelöst durch eine Vorrichtung zum Ziehen eines Einkristalls aus Halbleitermaterial nach der CZ-Methode aus einer Schmelze, umfassend
einen Tiegel zum Aufnehmen der Schmelze;
eine Widerstandsheizung, die um den Tiegel herum angeordnet ist;
ein Kamerasystem zum Beobachten einer Phasengrenze zwischen der Schmelze und dem wachsenden Einkristall, wobei das Kamerasystem eine optische Achse aufweist; einen Hitzeschild, der im Bereich seines unteren Endes kegelstumpfförmig mit sich verjüngendem Durchmesser ausgebildet ist und der über dem Tiegel angeordnet ist und den wachsenden Einkristall umgibt;
ein ringförmiges Element zum Auffangen von Partikeln, das von einer inneren Seitenfläche des Hitzeschilds aus nach innen ragt und an seinem inneren Ende eine nach oben gerichtete Fangkante aufweist, wobei die optische Achse des Kamerasystems zwischen der Fangkante und dem wachsenden Einkristall verläuft, dadurch gekennzeichnet, dass das ringförmige Element mit dem Hitzeschild lösbar verbunden ist.

Partikel, die das einkristalline Wachstum eines Kristalls aus Halbleitermaterial stören oder beenden können, entstehen nicht nur beim Resublimieren von SiO, sondern insbesondere auch beim Nachbeschicken von Halbleitermaterial, insbesondere in Form von Abrieb, der vom Hitzeschild stammt. Die vorliegende Erfindung stellt sicher, dass Versetzungsereignisse seltener werden und dass die Konzentration an von Partikeln stammenden und in der Schmelze gelösten Fremdelementen, insbesondere die Konzentration an Kohlenstoff, geringer wird.

Die erfindungsgemäße Vorrichtung umfasst einen Hitzeschild, der durch ein ringförmiges Element erweitert ist, das Partikel auffängt, die ohne dessen Vorhandensein in den Tiegel fallen würden. Das ringförmige Element ist lösbar mit dem Hitzeschild verbunden und ragt von einer inneren Seitenfläche des Hitzeschilds aus nach innen, das heißt, in Richtung des wachsenden Einkristalls und hat eine Querschnittsfläche, die an ihrem inneren Ende eine nach oben ragende Fangkante (trapping enclosure) aufweist. Partikel werden zwischen der Fangkante und dem Hitzeschild aufgefangen. Das ringförmige Element ragt zum wachsenden Einkristall, wobei die optische Achse des Kamerasystems zwischen der Fangkante und dem wachsenden Einkristall verläuft. Mit anderen Worten, die optische Achse trifft weder auf den Hitzeschild noch auf das ringförmige Element oder dessen Fangkante.

Der Hitzeschild ist vollständig oder zumindest im Bereich seines unteren Endes kegelstumpfartig mit sich verjüngendem Durchmesser ausgebildet.

Bevorzugt ist es, das ringförmige Element derart am Hitzeschild zu befestigen, dass ein Abstand des ringförmigen Elements zum unteren Ende des Hitzeschilds bestehen bleibt. Dieser Abstand beträgt vorzugsweise 10 mm bis 100 mm.

Das ringförmige Element besteht vorzugsweise aus demselben Material, aus dem die innere Seitenfläche des Hitzeschilds besteht.

Die Fangkante ragt vom inneren Ende des ringförmigen Elements nach oben, vorzugsweise über eine Strecke, die nicht weniger als 2 mm und nicht mehr als 100 mm beträgt. Des Weiteren ist die Fangkante vorzugsweise nach außen geneigt, also zum Hitzeschild geneigt, angeordnet.

Gegenstand der Erfindung ist darüber hinaus auch ein Verfahren zum Ziehen eines Einkristalls aus Halbleitermaterial in einer erfindungsgemäßen Vorrichtung, umfassend das Beschicken des Tiegels mit festem Halbleitermaterial;
das Schmelzen eines Teils oder der gesamten Masse des festen Halbleitermaterials; das Nachbeschicken des Tiegels mit weiterem festem Halbleitermaterial;
das Erhitzen des Tiegelinhalts, bis er vollständig geschmolzen ist; und das Ziehen des Einkristalls gemäß der CZ-Methode.

Das Halbleitermaterial besteht vorzugsweise aus Silizium, Germanium oder einer Mischung beider Elemente.

Der wachsende Einkristall umfasst einen zylindrischen Abschnitt mit einem Durchmesser von mindestens 200 mm, vorzugsweise mindestens 300 mm.

Die Erfindung wird nachfolgend unter Bezugnahme auf Zeichnungen erläutert.

### Kurzbeschreibung der Figuren

**Fig. 1** und **Fig. 3** zeigen jeweils eine Vorrichtung zum Ziehen eines Einkristalls aus Halbleitermaterial nach der CZ-Methode, die erfindungsgemäße Merkmale umfasst.
**Fig. 2** zeigt einen Ausschnitt eines Hitzeschilds, der mit einem erfindungsgemäßen ringförmigen Element verbunden ist.

### Liste der verwendeten Bezugszeichen

- **1**: Ziehkammer
- **2**: Tiegel
- **3**: Schmelze
- **4**: Kamerasystem
- **5**: Einkristall
- **6**: Welle
- **7**: Widerstandsheizung
- **8**: Ziehmechanismus
- **9**: Hitzeschild
- **10**: ringförmiges Element
- **11**: Fangkante
- **12**: optische Achse
- **13**: unteres Ende

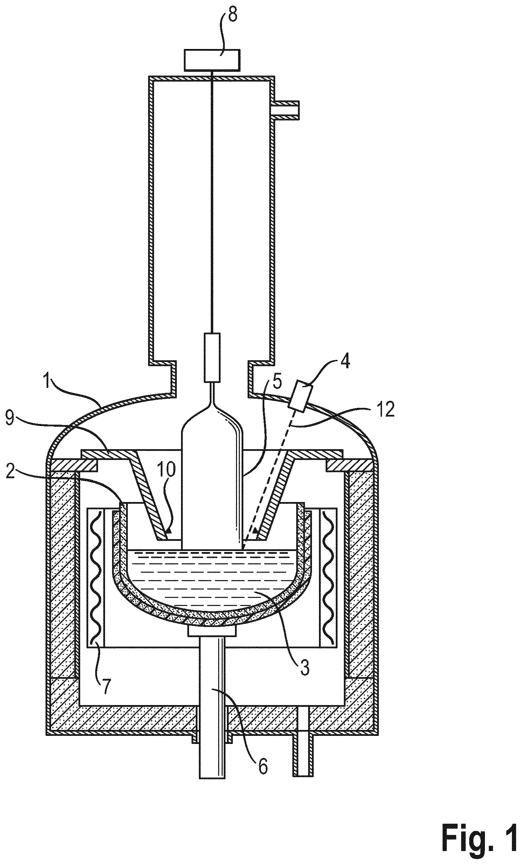

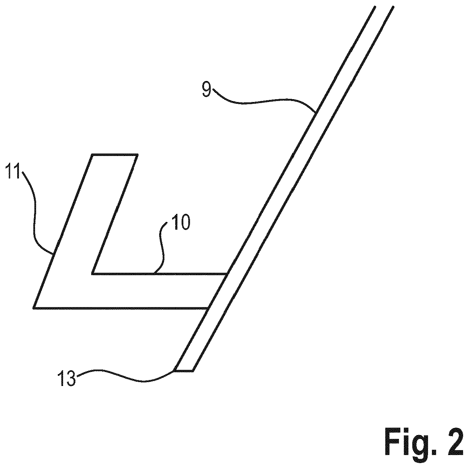

Die Vorrichtung gemäß Fig.1 umfasst eine Ziehkammer 1, in der ein Tiegel 2 zum Aufnehmen der Schmelze 3 untergebracht ist, und ein Kamerasystem 4 zum Beobachten einer Phasengrenze zwischen der Schmelze 3 und eines wachsenden Einkristalls 5. Der Tiegel 2 wird von einer Welle 6 getragen, die angehoben, abgesenkt und gedreht werden kann. Um den Tiegel 2 herum ist eine Widerstandsheizung 7 angeordnet, mit deren Hilfe festes Halbleitermaterial unter Bildung der Schmelze 3 geschmolzen wird. Der Einkristall 5 wird über einen Ziehmechanismus 8 aus der Schmelze gezogen. Über dem Tiegel 2 ist ein Hitzeschild 9 angeordnet, der den Einkristall 5 umgibt. Der Hitzeschild 9 ist im Bereich seines unteren Endes kegelstumpfförmig mit sich verjüngendem Durchmesser ausgebildet. Zwischen dem wachsenden Einkristall 5 und der inneren Seitenfläche des Hitzeschilds 9 ist ein ringförmiges Element 10 zum Auffangen von Partikeln vorhanden, das mit dem Hitzeschild 9 verbunden ist. Das ringförmige Element 10 ragt von der inneren Seitenfläche des Hitzeschilds 9 aus nach innen (in Richtung des wachsenden Einkristalls) und weist an seinem inneren Ende eine Fangkante 11 (Fig.2) auf, die nach oben gerichtet ist. Die Fangkante 11 wird von einer zu einem Rohr geschlossenen Wand gebildet. Erfindungsgemäß sind das ringförmige Element 10 und dessen Fangkante 11 derart ausgebildet, dass sie der optischen Achse 12 des Kamerasystems 4 nicht im Weg stehen, also die optische Achse 12 zwischen der Fangkante 11 und dem wachsenden Einkristall 5 verläuft.

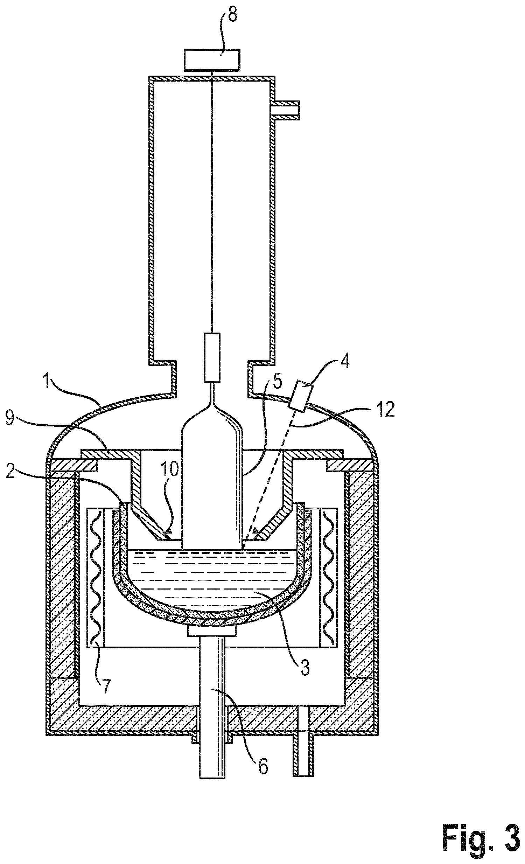

Die Vorrichtung gemäß Fig.3 umfasst im Unterschied zur Vorrichtung gemäß Fig.1 einen Hitzeschild 9, der nur im Bereich seines unteren Endes mit sich verjüngendem Durchmesser ausgebildet ist. Im Bereich darüber hat er eine zylindrische Form.

Fig.2 zeigt einen Ausschnitt des ringförmigen Elements 10 und des Hitzeschilds 9 im Querschnitt. Bei der gezeigten Ausführungsform hat das ringförmige Element 10 etwas Abstand zum unteren Ende 13 des Hitzeschilds 9 und die Fangkante 11 ist zum Hitzeschild 9 geneigt ausgebildet.

Die Vorrichtung kann auch eine oder mehrere Spulen umfassen, die ein Magnetfeld erzeugen, das der Schmelze aufgeprägt wird.

## Patentansprüche

1. Vorrichtung zum Ziehen eines Einkristalls aus Halbleitermaterial nach der CZ-Methode aus einer Schmelze, umfassend
einen Tiegel zum Aufnehmen der Schmelze;
eine Widerstandsheizung, die um den Tiegel herum angeordnet ist;
ein Kamerasystem zum Beobachten einer Phasengrenze zwischen der Schmelze und dem wachsenden Einkristall, wobei das Kamerasystem eine optische Achse aufweist; einen Hitzeschild, der im Bereich seines unteren Endes kegelstumpfförmig mit sich verjüngendem Durchmesser ausgebildet ist und der über dem Tiegel angeordnet ist und den wachsenden Einkristall umgibt;
ein ringförmiges Element zum Auffangen von Partikeln, das von einer inneren Seitenfläche des Hitzeschilds aus nach innen ragt und an seinem inneren Ende eine nach oben gerichtete Fangkante aufweist, wobei die optische Achse des Kamerasystems zwischen der Fangkante und dem wachsenden Einkristall verläuft, **dadurch gekennzeichnet, dass** das ringförmige Element mit dem Hitzeschild lösbar verbunden ist.

2. Vorrichtung nach Anspruch 1, **dadurch gekennzeichnet, dass** das ringförmige Element einen Abstand zum unteren Ende des Hitzeschilds hat.

3. Vorrichtung nach Anspruch 2, **dadurch gekennzeichnet, dass** der Abstand 10 mm bis 100 mm beträgt.

4. Vorrichtung nach einem der Ansprüche 1 bis 3, **dadurch gekennzeichnet, dass** die Fangkante zum Hitzeschild neigend angeordnet ist.

5. Verfahren zum Ziehen eines Einkristalls aus Halbleitermaterial in einer Vorrichtung gemäß einem der Ansprüche 1 bis 4, umfassend
das Beschicken des Tiegels mit festem Halbleitermaterial;
das Schmelzen eines Teils oder der gesamten Masse des festen Halbleitermaterials; das Nachbeschicken des Tiegels mit weiterem festem Halbleitermaterial;
das Erhitzen des Tiegelinhalts, bis er vollständig geschmolzen ist; und
das Ziehen des Einkristalls gemäß der CZ-Methode.

## Claims

1. Apparatus for pulling a single crystal of semiconductor material from a melt by the CZ method, comprising
a crucible for holding the melt;
a resistive heater disposed around the crucible; a camera system for observing a phase boundary between the melt and the growing single crystal, the camera system having an optical axis; a heat shield formed in a frustoconical shape with a tapering diameter in the region of its lower end and disposed above the crucible and surrounding the growing single crystal;
an annular element for catching particles, projecting inwardly from an inner side surface of the heat shield and having an upwardly directed catching edge at its inner end, the optical axis of the camera system extending between the catching edge and the growing single crystal, **characterized in that** the annular element is detachably connected to the heat shield.

2. The apparatus of claim 1, **characterized in that** the annular member is spaced from the lower end of the heat shield.

3. Device according to claim 2, **characterized in that** the distance is 10 mm to 100 mm.

4. Device according to one of the claims 1 to 3, **characterized in that** the catching edge is arranged inclined to the heat shield.

5. Method of pulling a single crystal of semiconductor material in a device according to any one of claims 1 to 4, comprising
the charging of the crucible with solid semiconductor material;
the melting of part or all of the mass of solid semiconductor material;
the reloading of the crucible with further solid semiconductor material;
heating the contents of the crucible until they are completely melted; and
the pulling of the single crystal according to the CZ method.

## Revendications

1. Dispositif pour le tirage d'un monocristal de matériau semi-conducteur selon la méthode CZ à partir d'une masse fondue, comprenant
un creuset pour recueillir la masse fondue ;
un chauffage par résistance disposé autour du creuset ; un système de caméra pour observer une limite de phase entre la masse fondue et le monocristal en croissance, le système de caméra ayant un axe optique ; un bouclier thermique qui est en forme de tronc de cône à diamètre décroissant dans la région de son extrémité inférieure et qui est disposé au-dessus du creuset et entoure le monocristal en croissance ;
un élément annulaire pour capturer des particules, s'étendant vers l'intérieur à partir d'une surface latérale intérieure de l'écran thermique et ayant un bord de capture dirigé vers le haut à son extrémité intérieure, l'axe optique du système de caméra s'étendant entre le bord de capture et le monocristal en croissance, **caractérisé en ce que** l'élément annulaire est connecté de manière amovible à l'écran thermique.

2. Dispositif selon la revendication 1, **caractérisé en ce que** l'élément annulaire est espacé de l'extrémité inférieure du bouclier thermique.

3. Dispositif selon la revendication 2, **caractérisé en ce que** la distance est comprise entre 10 mm et 100 mm.

4. Dispositif selon l'une des revendications 1 à 3, **caractérisé en ce que** le bord de capture est disposé de manière à être incliné par rapport à l'écran thermique.

5. Procédé de tirage d'un monocristal de matériau semi-conducteur dans un dispositif
selon l'une quelconque des revendications 1 à 4, comprenant le chargement du creuset avec du matériau semi-conducteur solide ;
la fusion d'une partie ou de la totalité de la masse du matériau semi-conducteur solide ;
le rechargement du creuset avec d'autres matériaux semi-conducteurs solides ;
le chauffage du contenu du creuset jusqu'à ce qu'il soit complètement fondu ; et
le tirage du monocristal selon la méthode CZ.
